Europäisches Patentamt

European Patent Office

Office européen des brevets

(11) Publication number: **0 140 507 B1**

# EUROPEAN PATENT SPECIFICATION

(45) Date of publication of patent specification: **15.04.92**  (51) Int. Cl.5: **H03M  1/38**

(21) Application number: **84305593.0**

(22) Date of filing: **17.08.84**

(54) A/D Converter.

(30) Priority: **22.09.83 JP 174083/83**

(43) Date of publication of application:
**08.05.85 Bulletin  85/19**

(45) Publication of the grant of the patent:
**15.04.92 Bulletin  92/16**

(84) Designated Contracting States:
**DE FR GB**

(56) References cited:

**PATENT ABSTRACTS OF JAPAN, vol 6, no. 264 (E-150)[1142], 23rd December 1982; & JP-A-57 160 219 (FUJITSU K.K.) 02-10-1982**

**PATENT ABSTRACTS OF JAPAN, vol. 7, no. 140 (E-182)[1285], 18th June 1983; & JP-A-58 53 222 (NIPPON DENKI K.K.) 29-03-1983**

**D. Seitzer, G. Pretzl, N.A. Nowdy, "Electronic Analog -to- Digital Converters", John Wiley and Sons, 1983, pages 189-191.**

(73) Proprietor: **FUJITSU LIMITED
1015, Kamikodanaka Nakahara-ku
Kawasaki-shi Kanagawa 211(JP)**

(72) Inventor: **Nunokawa, Hideo
Yutaka-so, 1181, Kamikodanaka Nakahara-ku
Kawasaki-shi Kanagawa 211(JP)**

(74) Representative: **Sunderland, James Harry et al
HASELTINE LAKE & CO Hazlitt House 28
Southampton Buildings Chancery Lane
London WC2A 1AT(GB)**

# Description

The present invention relates to an A/D converter, more particularly, it relates to a sequential comparison type A/D converter.

A conventional type A/D converter includes a D/A converter which generates a reference voltage; a comparator which compares a sampled analog input voltage with the reference voltage; and a sequential comparator control circuit which repeats comparison steps consisting of inputting a digital value into the D/A converter in accordance with the result of the determination by the comparator, so as to obtain the result of the conversion. The comparator receives the sampled analog signal input at its first input, and receives an analog signal from the D/A converter at its second input, as a reference voltage. These signals received at the first input and the second input are compared in the comparator and a comparator output signal is supplied to a sequential comparison control circuit. In the sequential comparison control circuit, a digital value is varied in accordance with the output of the comparator, and corresponding digital signals are supplied to the D/A converter, which converts the digital signals to an analog signal. The analog signal is supplied as a new reference voltage to the second input of the comparator, which carries out a second comparison, and so on. As a result, comparisons are sequentially carried out a first time, a second time, and so on, until the first input (sampled voltage) and the second input (reference voltage) are equal to each other, at which point the digital signal corresponding to the sampled analog signal value is obtained.

In the sequential comparison system described above, in general the comparison is started with an initial voltage of one half of the maximum reference voltage usually generated in the D/A converter.

However, in this case, when the sampled analog input voltage varies over a wide range, a malfunction may occur in the comparator, as explained in detail hereinafter.

If the comparison is started from 3/4 of the maximum reference voltage, as disclosed in JP-A-57-160,219 and JP-A-58-53,222, the above-mentioned malfunction is eliminated. However, in this case, when the next digital value is set in accordance with the comparison result, an erroneous comparison may occur, as explained in detail hereinafter.

An embodiment of the present invention can provide an A/D converter in a 3/4 reference voltage sequential comparison system which can eliminate a cause of malfunctions in the sequential comparison process.

According to the present invention, there is provided an A/D converter comprising a D/A converter which generates a reference voltage, a comparator which compares a sampled analog input voltage with said reference voltage, and a sequential comparison control circuit which repeats a comparison step of outputting a digital value to said D/A converter in accordance with the result of the comparison by said comparator, until a digital value, corresponding to the sampled analog input voltage, is formed, said sequential comparison control circuit comprising a set of sequential comparison registers corresponding in number to the number of bits in said digital value, each of which receives the output of said comparator circuit; wherein said sequential comparison control circuit inputs an initial digital value to said D/A converter so that a reference voltage larger than one-half of a maximum allowable value of said analog input is supplied to the comparator at the time the A/D conversion commences with a first comparison step, said sequential comparison control circuit being constituted so as to hold or change the content of a specific bit of the digital value input to said D/A converter at each comparison step in accordance with the result of the comparison, said specific bit depending on the comparison step, and being, for the first comparison step, any bit except the most significant bit; characterised in that:- said sequential comparison control circuit further comprises an inverter circuit which is connected to the comparison register holding the most significant bit from the comparison register holding the next most significant bit and operable to fix an output of the comparison register holding the most significant bit at a predetermined value, whereby at the first comparison step, if said analog input voltage is determined to be larger than said reference voltage, the most significant bit of said initial digital value is fixed until the A/D conversion is finished, regardless of the results of determinations by said comparator in the subsequent comparison steps.

Reference is made, by way of example, to the accompanying drawings in which:-

Fig. 1 is a block diagram of one example of a conventional A/D converter using a sequential comparison system;

Fig. 2A is a detailed circuit diagram of a comparator shown in Fig. 1;

Figs. 2B and 2C are waveforms and a diagram showing an operation of the comparator shown in Fig. 2A;

Fig. 3A is a diagram showing an operation of the A/D converter shown in Fig. 1;

Fig. 3B is a diagram showing the algorithm of the A/D converter shown in Fig. 1;

Fig. 4 is a block diagram of part of an A/D converter according to an embodiment of the present invention;

Fig. 5 is a time chart explaining operation of the part of an A/D converter shown in Fig. 4;

Fig. 6 is a detailed circuit diagram of the sequential comparison registers 12a and 12b shown in Fig. 4;

Fig. 7 is a detailed circuit diagram of the sequential comparison registers 12c to 12h shown in Fig. 4; and

Figs. 8A and 8B are diagrams showing signal levels during the operation of the circuit shown in Fig. 7.

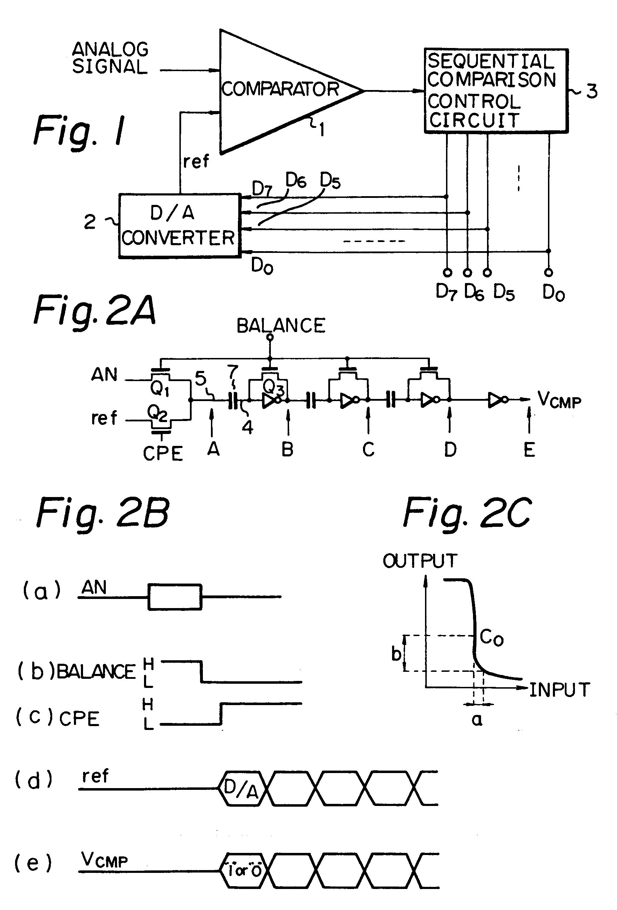

Figure 1 shows a block diagram of a sequential comparison type A/D converter. In Fig. 1, a comparator 1 receives an analog signal input to a first input, and a second input of the comparator 1 receives an analog signal input (reference voltage) from a DA converter 2. These signals received at the first input and the second input are compared in the comparator 1, and the comparison output signal is supplied to a sequential comparison control circuit 3. In the sequential comparator control circuit 3, a digital value is varied in accordance with the output of the comparator 1, so that digital signals $D_0$, ... $D_5$, $D_6$, $D_7$ are supplied to the DA converter, which convert the digital signals $D_0$, ...,$D_7$ to an analog signal. The analog signal is supplied as a new reference voltage to the second input of the comparator 1, which carries out a second comparison. As a result, comparisons are sequentially carried out a first time, a second time, and so on, until the first input and the second input are equal to each other, at which point the digital signals $D_0$, ..., $D_7$ corresponding to the analog signal value are obtained at output terminals of the sequential comparison control circuit 3.

In the circuit shown in Fig. 1, the comparator 1 is formed as shown in Fig. 2A. Fig. 2B shows a timing chart illustrating (a) a sampled analog signal, (b) a balance signal (BALANCE), (c) a comparator enable signal (CPE), (d) a reference signal, and (e) an output signal $V_{CMP}$. In Fig. 2A, a balance signal BALANCE (Fig. 2B (b)) is at H (high level), the analog input voltage (Fig. 2B (a)) is input via a transistor $Q_1$, the CPE signal (Fig. 2B (c)) then becomes H (high level), i.e., enters the comparison mode, and the D/A output (Fig. 2B (d)) is input via a transistor $Q_2$. At this time, a voltage corresponding to a potential difference "a" (see Fig. 2C) between the analog input and the output of the D/A converter is generated at a node A (Fig. 2A). This potential difference "a" is amplified to "b" (see Fig. 2c) at a node B (Fig. 2A), as shown in Fig. 2C. As a result, a further amplified voltage is obtained at nodes C, D, and E (Fig. 2A). For example, if it is assumed that the analog input voltage is 10mV, the D/A converter output is 12 mV, and the amplification factor of each inverter is 10, the voltage change of 2 mV at nodes A and 4 gives output voltage changes of -20 mV, + 200 mV, and -2.0 V at nodes B, C, and D respectively (Fig. 2A), and an H (high level) signal is output at node E. The H signal indicates that the reference voltage (ref) (D/A converter output) is higher than the analog input (AN).

In the sequential comparison system shown in Fig. 2A, the comparison is started from 1/2 of the maximum reference voltage usually generated in the D/A converter. However, when the analog input voltage varies over a wide range, a malfunction is produced in the comparator, as explained in detail below with reference to Fig. 2A.

When the balance signal BALANCE is at H (high level), that is, the comparator is in the balance mode, the voltage at a point 4 is usually about 1.2V, which is equal to the input threshold voltage of the inverter. In this state, if the maximum voltage of the analog signal, for example, 5 V, is supplied, the voltage at a point 5 becomes 5 V, thus a potential difference of 3.8 V appears between two terminals of the capacitor 7, and a charge 3.8C (where C is the capacitance of the capacitor 7) is stored in the capacitor 7. Then the balance signal BALANCE goes to L (low level).

The maximum reference voltage REF is assumed to be 5.6V, thus the 1/2 maximum reference voltage (ref = $\frac{1}{2}$ REF) is 2.8 V. This 2.8 V is supplied to the comparator1 as the initial reference output of the D/A converter. When the comparator enable signal CPE becomes H, the voltage at point 5 becomes 2.8 V, which causes the voltage at point 4 to fall to less than -1.0 V due to the capacitive coupling via the capacitor 7. Then a PN junction formed between a diffusion region of the MOS transistor $Q_3$ and a semiconductor substrate is forwardly biased, and therefore, a current flows from the semiconductor substrate grounded to earth potential to point 4, and the voltage at point 4 becomes 0 V. Accordingly, the amount of electric charge in the capacitor 7 changes from 3.7C (3.8C) to 2.8C, causing a malfunction. However, if the comparison is started from the 3/4 maximum reference voltage (ref = 3/4 REF), the voltage at point 5 is 4.2 V (the maximum reference voltage REF is assumed to be 5.6 V), and the voltage at point 4 falls only to about 0.4 volt, eliminating the aforementioned drawback.

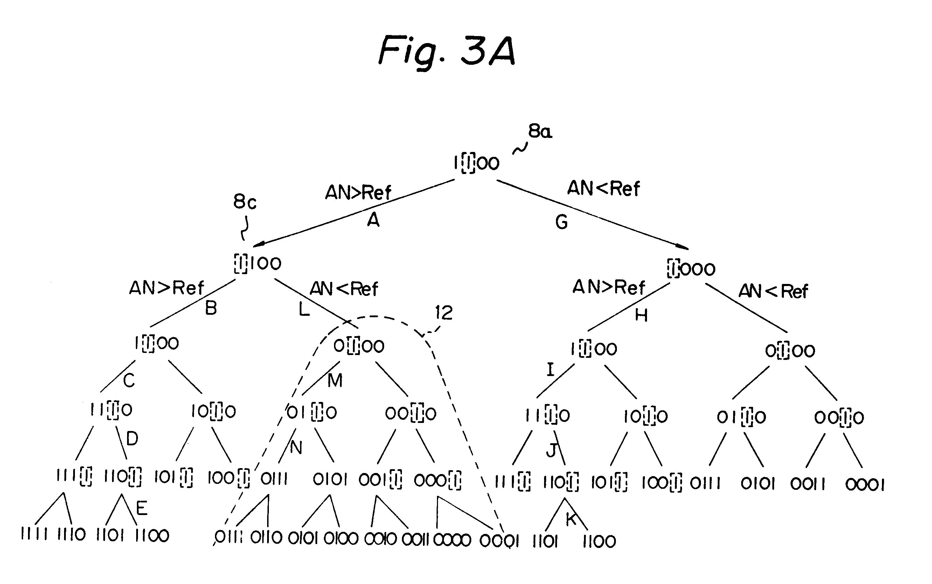

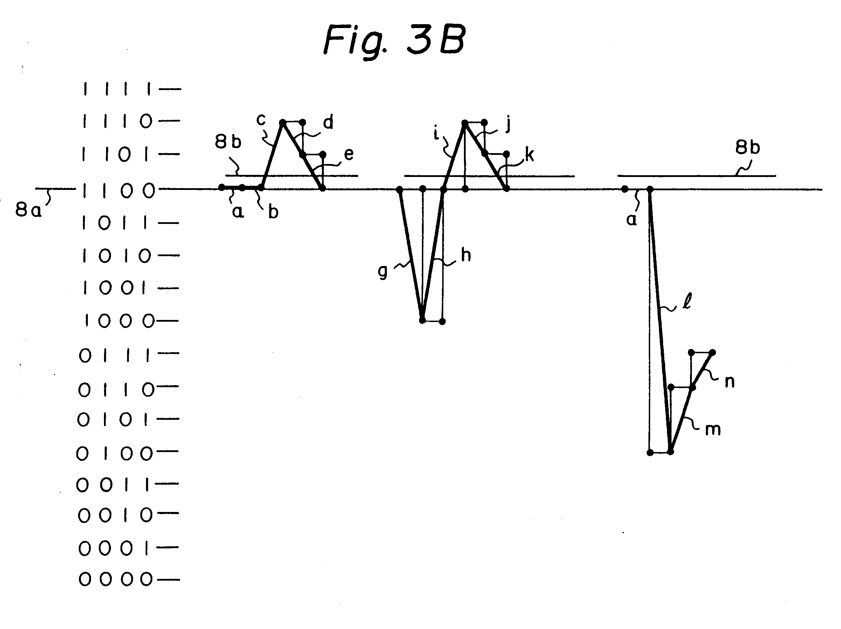

This is achieved by setting an initial value of the sequential comparison register in the sequential comparison control circuit 3 of $(C0)_H$ instead of $(80)_H$ when the resolution is 8 bits. However, in this method, when the next value is set in accordance with the comparison result, an error comparison routine (malfunction) may occur. This state is shown in Figs. 3A and 3B.

Before explaining Figs. 3A and 3B, an explanation is given of the algorithm of the sequential comparison control circuit. That is, the comparison step is commenced with any bit except the most significant bit, and action is taken according to the following algorithm:

(a) When the sampled signal is larger, i.e. at "H", than the initial value, the compared bit is placed to the value "1", and the next bit to be compared is also placed to the value "1".

(b) When the sampled signal is smaller than the initial value, the compared bit is placed to the value "0", and the next bit to be compared is placed to the value "1".

In Figs. 3A and 3B, Ref denotes the current reference voltage level corresponding to the current digital value (previously denoted ref), 8a denotes an initial value, and 8b denotes an analog signal (AN) to be compared. In Fig. 3B, in the normal state the analog value 8b is compared with the initial value 8a, in which the comparison process is effected by a pass a→b→c→d→e and the compared value is set to the value "1100" (that is, $C0_H$). This pass is shown in Fig. 3A as A→B→C→D→E. In Fig. 3B, when the analog signal 8b is determined as smaller than the initial value 8a at a first comparison, i.e., AN < Ref at the first time, the comparison process is effected by another pass g→h→i→j→k and the compared value is set to the value "1100". This pass is shown in Fig. 3A as G→H→I→J→K.

However, in Fig. 3B, when the analog signal 8b is determined as smaller than the reference value 8c at a second time (comparison step), i.e., AN < Ref, the comparison process is effected by another pass a → l → m → n and, finally, the value "0111" is output. This pass is shown in Fig. 3A as A→L→M→N. The output value of "0111" is seriously in error compared with the correct value of "1100". Such a large error cannot occur for analog signals determined as smaller than the initial value 8a at a first comparison. Note: In Fig. 3A, reference numeral 12 illustrates a malfunction mode region.

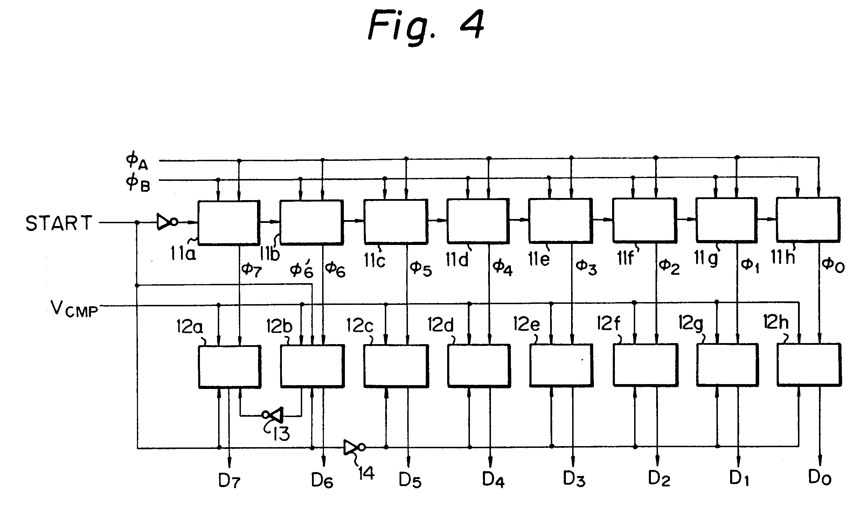

According to the present invention, in order to eliminate such malfunctions in the sequential comparison register, when an analog signal value is determined as larger than the reference value at a first comparison, no comparison below a second comparison is carried out (no action is taken at a second comparison). A circuit diagram for realizing this aim in accordance with the present invention is shown in Fig. 4. In Fig. 4, 11a through 11h denote shift registers, 12a through 12h denote sequential comparison registers, and 13 and 14 denote inverters, respectively. In Fig. 4, the shift registers 11a to 11h are driven by clock pulses $\emptyset_A$ and $\emptyset_B$ in such a manner that, when the start pulse is applied to the first shift register 11a and the pulse is shifted, the pulse is shifted sequentially. That is, the start pulse is supplied to the first shift register 10a and the sequential comparison registers 12a to 12h, the inverter 13 feeds back the output of the sequential comparison register 12b to the register 12a, as explained hereinafter, and the inverter 14 inhibits values lower than three bits, for further transmission. The output terminals $D_7$ to $D_0$ correspond to those of the sequential comparison control circuit 3 shown in Fig. 1.

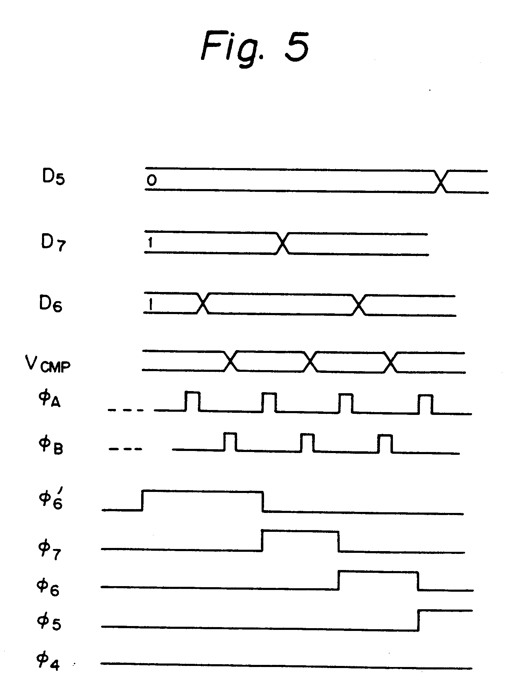

Figure 5 is a time chart explaining the operation of the circuit shown in Fig. 4. As shown in the Figure, the start pulse $\emptyset_6'$ is supplied to the first shift register 12a, and pulses $\emptyset_7$, $\emptyset_6$, $\emptyset_5$ and $\emptyset_4$ are generated by the clock pulses $\emptyset_A$. When the clock pulse $\emptyset_A$ receives the output of the comparator $V_{CMP}$, outputs 1, 1, 0 are generated at the output terminals $D_7$, $D_6$, and $D_5$ sequentially.

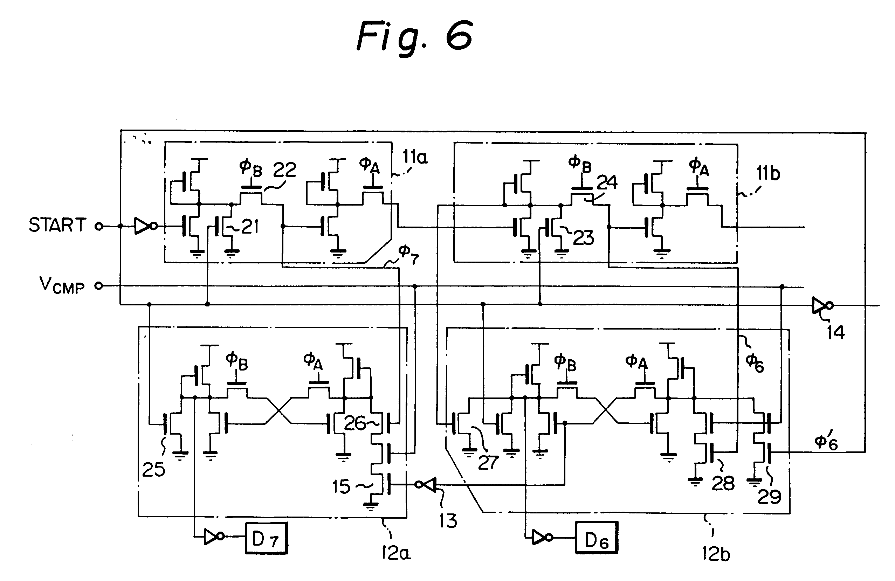

Figure 6 shows a detailed circuit diagram of the sequential comparison registers 12a, 12b, and the shift registers 11a, 11b shown in Fig. 4. In Figs. 4 and 6, the inverters 13 and 14 are added to the conventional circuit for the purpose of carrying out the present invention. In the circuit shown in Fig. 6, when the start pulse START is supplied, the base of the transistor 21 becomes high (reaches a high voltage), so that the collector of the transistor 21 and the output clock $\emptyset_7$ become low. Similarly, the output clock $\emptyset_6$ also becomes low. The base of the transistor 29 becomes high and the bases of the transistor 25 and 27 also become high, so that the collectors of the transistors 25 and 27 become low. Accordingly, high voltage levels appear at the terminals $D_6$ and $D_7$. In this state, when the output $D_6$ of the comparator register 12b is determined as high level (H level), the output of the inverter 13 becomes low level, and the transistor 15 is placed in an off state. Therefore, the output $D_7$ of the comparison register 12a is fixed at a high level "1" regardless of the input level thereof. The effect of this is that, after a first comparison at which AN > Ref is determined, the result of a second comparison, which is performed for setting the most significant bit $D_7$, is ignored. (Third, fourth, etc. comparisons upon bits $D_6$, $D_5$ etc., proceed as normal.)

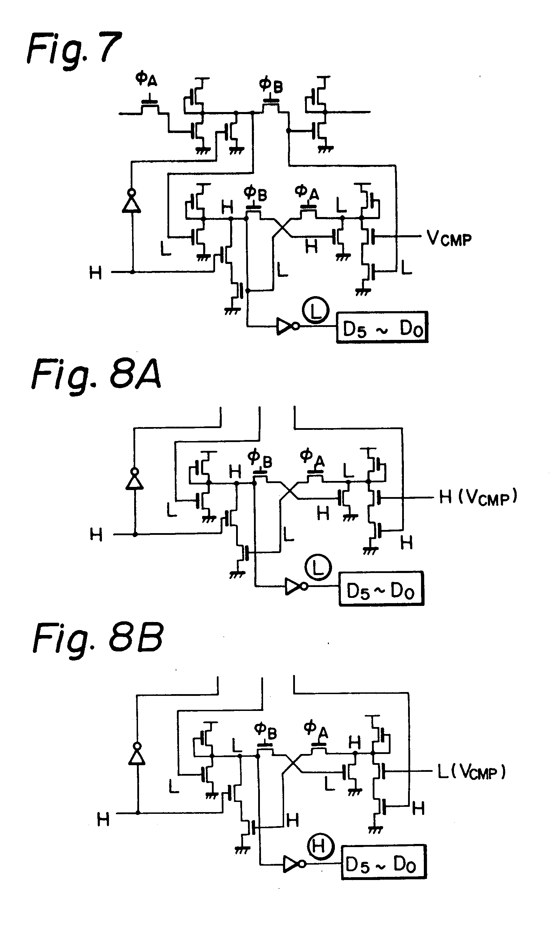

Figure 7 shows a detailed circuit diagram of the registers 12c through 12h shown in Fig. 4. Figure 7 shows the state wherein the registers are not in the enable (ENABLE) mode, and the symbols H and L show the high level state and the low level state at those points, respectively. Fig. 8(A) shows the levels at each point when the register is in the enable state and ref > AN is H level. In this case, the bit output levels $D_5$ to $D_0$ become L level. Figure 8 (B) shows the levels at each point when ref > AN is L level. In this case, the bit output levels $D_5$ to $D_0$ become H level.

As explained in detail above, according to the present invention, the malfunction mode of the sequential comparison register in the A/D converter in the 3/4 reference voltage sequential comparison system can be eliminated, so that a great improvement is effected by the present invention over the conventional system.

The above embodiment of the present invention is used for a 3/4 reference voltage sequential comparison system. However, it is understood that the present invention is applicable also when any other reference voltage larger than one half (1/2) of a maximum allowable value of the analog input is supplied to the comparator at the time the A/D conversion commences. Accordingly the sequential control circuit is constituted so as to hold or change the content of the digital value input to the D/A converter at each comparison step in accordance with the result of the comparison, and the comparison step is commenced with any bit except the most significant bit.

An A/D converter includes a D/A converter which generates a reference voltage; a comparator which compares a sampled analog input voltage with the reference voltage; and a sequential comparison control circuit which repeats comparison steps comprising inputting a digital value into the D/A converter in accordance with the result of the determination by the comparator, so as to obtain the result of the conversion.

The sequential comparison control circuit inputs an initial digital value to the D/A converter so that a reference voltage larger than one half (1/2) of a maximum allowable value of the analog input is supplied to the comparator at the time the A/D conversion commences. Accordingly, the sequential control circuit is constituted so as to hold or change the content of the digital value input to the D/A converter at each comparison step in accordance with the result of the comparison.

The comparison step is commenced with any bit except the most significant bit.

At this time, when the analog input voltage is determined to be larger than the reference voltage, the most significant bit of the initial digital value is fixed (not changed) until the A/D conversion is finished, regardless of the result of the determination by the comparator.

**Claims**

1. An A/D converter comprising:-
 a D/A converter (2) which generates a reference voltage (Ref);
 a comparator (1) which compares a sampled analog input voltage (AN) with said reference voltage (Ref); and
 a sequential comparison control circuit (3) which repeats a comparison step of outputting a digital value ($D_7$ ... $D_0$) to said D/A converter (2) in accordance with the result of the comparison by said comparator (1), until a digital value, corresponding to the sampled analog input voltage (AN), is formed, said sequential comparison control circuit (3) comprising a set of sequential comparison registers (12a ... 12h) corresponding in number to the number of bits in said digital value ($D_7$ ... $D_0$), each of which receives the output of said comparator circuit;
 wherein said sequential comparison control circuit (3) inputs an initial digital value to said D/A converter (2) so that a reference voltage (Ref) larger than one-half (1/2) of a maximum allowable value of said analog input is supplied to the comparator (1) at the time the A/D conversion commences with a first comparison step, said sequential comparison control circuit (3) being constituted so as to hold or change the content of a specific bit of the digital value ($D_7$ ... $D_0$) input to said D/A converter (2) at each comparison step in accordance with the result of the comparison, said specific bit depending on the comparison step, and being, for the first comparison step, any bit except the most significant bit ($D_7$);
 characterised in that:-
 said sequential comparison control circuit (3) further comprises an inverter circuit (13) which is connected to the comparison register (12a) holding the most significant bit ($D_7$) from the comparison register (12b) holding the next most significant bit ($D_6$) and operable to fix an output of the comparison register (12a) holding the most significant bit at a predetermined value, whereby at the first comparison step, if said analog input voltage (AN) is determined to be larger than said reference voltage (Ref), the most significant bit ($D_7$) of said initial digital value is fixed until the A/D conversion is finished, regardless of the results of determinations by said comparator in the subsequent comparison steps.

2. An A/D converter according to claim 1, wherein a reference voltage of at least 3/4 of a maximum allowable value of said analog input is used as the reference voltage (Ref) larger than one-half of a maximum allowable value of said analog input.

3. An A/D converter according to claim 1 or 2, wherein said sequential comparison control circuit (3) further comprises a plurality of shift registers (11a to 11h) corresponding in number to the number of bits in the digital value, which are connected in series and driven by clock pulses ($\emptyset_A$, $\emptyset_B$), and when the first shift register (11a) receives a start pulse (START), said shift registers output respective pulses ($\emptyset_7$ ... $\emptyset_0$) which are shifted sequentially,

each of said sequential comparison registers (12a to 12h) being driven by the output ($\emptyset_7 \dots \emptyset_0$) of a respective one of the shift registers (11a ... 11h), and by said start pulse (START); and

a second inverter circuit (14) which is connected between the input of said start pulse (START) into said comparison register (12b) holding the next most significant bit and the input of said start pulse into an adjacent sequential comparison register (12c).

## Revendications

1. Convertisseur analogique/numérique comprenant:

un convertisseur numérique/analogique (2) qui génère une tension de référence (Ref);

un comparateur (1) qui compare une tension analogique échantillonnée d'entrée (AN) à ladite tension de référence (Ref); et

un circuit de commande de comparaison séquentielle (3) qui répète une opération de comparaison pour la sortie d'une valeur numérique ($D_7...D_0$) vers ledit convertisseur N/A (2) selon le résultat de la comparaison exécutée par ledit comparateur (1), jusqu'à ce qu'une valeur numérique, correspondant à la tension analogique échantillonnée d'entrée (AN), soit obtenue, ledit circuit de commande de comparaison séquentielle (3) comprenant un ensemble de registres de comparaison séquentielle (12a...12h) correspondant en nombre au nombre de bits de ladite valeur numérique ($D_7...D_0$), dont chacun reçoit le signal de sortie dudit circuit comparateur;

dans lequel ledit circuit de commande de comparaison séquentielle (3) entre une valeur numérique initiale dans ledit convertisseur N/A (2) de telle sorte qu'une tension de référence (Ref) supérieure à la moitié (1/2) d'une valeur admise maximale de ladite tension analogique d'entrée est fournie au comparateur (1) au temps où la conversion A/N commence avec une première opération de comparison, ledit circuit de commande de comparaison séquentielle (3) étant constitué de manière à maintenir ou changer le niveau d'un bit spécifique de la valeur numérique ($D_7...D_0$) entrée dans ledit convertisseur N/A (2) à chaque opération de comparaison selon le résultat de la comparaison, ledit bit spécifique dépendant de l'opération de comparaison, et ce bit étant, pour la première opération de comparaison, n'importe quel bit à l'exception du bit de poids le plus fort ($D_7$);

caractérisé en ce que:

ledit circuit de commande de comparaison séquentielle (3) comprend en outre un circuit inverseur (13) qui est connecté au registre de comparaison (12a) contenant le bit de poids le plus fort ($D_7$) à partir du registre de comparaison (12b) contenant le bit de poids fort suivant ($D_6$) et pouvant être rendu actif pour fixer le signal de sortie du registre de comparaison (12a) contenant le bit de poids le plus fort à une valeur prédéterminée, et de cette façon, pendant la première opération de comparaison, si ladite tension analogique d'entrée (AN) est déterminée comme étant supérieure à ladite tension de référence (Ref), le bit de poids le plus fort ($D_7$) de ladite valeur numérique initiale est fixé jusqu'à ce que la conversion A/N soit terminée, indépendamment des résultats des déterminations faites par ledit comparateur dans les opérations de comparaison suivantes.

2. Convertisseur analogique-numérique selon la revendication 1, dans lequel une tension de référence égale à au moins 3/4 d'une valeur admise maximale de ladite tension analogique d'entrée est utilisée comme tension de référence (Ref) supérieure à la moitié d'une valeur admise maximale de ladite tension analogique d'entrée.

3. Convertisseur analogique-numérique selon l'une quelconque des revendications 1 et 2, dans lequel ledit circuit de commande de comparaison séquentielle (3) comprend en outre une pluralité de registres à décalage (11a à 11h) correspondant en nombre au nombre de bits de la valeur numérique, qui sont connectés en série et commandés par des impulsions d'horloge ($\emptyset_A, \emptyset_B$), et, quand le premier registre à décalage (11a) reçoit une impulsion de début (DEBUT), lesdits registres à décalages sortent des impulsions respectives ($\emptyset_7...\emptyset_0$) qui sont décalées séquentiellement,

chacun desdits registres de comparaison séquentielle (12a à 12h) étant commandé par le signal de sortie ($\emptyset_7...\emptyset_0$) d'un registre respectif des registres à décalage (11a...11h), et par ladite impulsion de début (DEBUT); et

un deuxième circuit inverseur (14) qui est connecté entre l'entrée de ladite impulsion de début (DEBUT) dans ledit registre de comparaison (12b) contenant le bit de poids fort suivant et l'entrée de ladite impulsion de début dans un registre de comparaison séquentielle voisin (12c).

## Patentansprüche

1. Ein A/D-Konverter mit:-

einem D/A-Konverter (2), der eine Referenzspannung (Ref) erzeugt;

einem Komparator (1), der eine abgetastete analoge Eingangsspannung (AN) mit der Referenzspannung (Ref) vergleicht; und

einer sequentiellen Vergleichssteuerschaltung (3), welche einen Vergleichsschritt der Ausgabe eines digitalen Wertes ($D_7$ ... $D_0$) mit dem D/A-Konverter (2) wiederholt, in Übereinstimmung mit dem Ergebnis des Vergleichs durch den Komparator (1), bis ein digitaler Wert, der der abgetasteten analogen Eingangsspannung (AN) entspricht, gebildet ist, welche sequentielle Vergleichssteuerschaltung (3) einen Satz von sequentiellen Vergleichsregistern (12a ... 12 h) umfaßt, deren Anzahl der Zahl der Bits des genannten digitalen Wertes ($D_7$ ... $D_0$) entspricht, von denen jedes den Ausgang der Komparatorschaltung empfängt;

bei dem die sequentielle Vergleichssteuerschaltung (3) einen anfänglichen digitalen Wert in den D/A-Konverter (2) eingibt, so daß eine Referenzspannung (Ref) größer als einhalb (1/2) des maximal zulässigen Wertes der genannten analogen Eingabe an den Komparator (1) geliefert wird, zu der Zeit, zu der die A/D-Konversion mit einem ersten Vergleichsschritt beginnt, welche sequentielle Vergleichssteuerschaltung (3) so ausgebildet ist, daß sie den Inhalt eines spezifischen Bit des digitalen Wertes ($D_7$ ... $D_0$), der dem D/A-Konverter (2) bei jedem Vergleichsschritt eingegeben wird, in Übereinstimmung mit dem Ergebnis des Vergleichs hält oder ändert, welches spezifische Bit von dem Vergleichsschritt abhängt, und für den ersten Vergleichsschritt irgendein Bit ist, mit Ausnahme des höchstwertigsten Bit ($D_7$);

dadurch gekennzeichnet, daß:-
die sequentielle Vergleichssteuerschaltung (3) ferner eine Inverterschaltung (13) umfaßt, die mit dem Vergleichsregister (12a) verbunden ist, welches das höchstwertigste Bit ($D_7$) von dem Vergleichsregister (12b) hält, welches das nächsthöchstwertigste Bit ($D_6$) hält und betreibbar ist, um einen Ausgang des Vergleichsregisters (12a), das das höchstwertigste Bit hält, auf einen vorbestimmten Wert zu fixieren, wodurch bei dem ersten Vergleichsschritt, falls festgestellt wird, daß die genannte analoge Eingangsspannung (AN) größer als die genannte Referenzspannung (Ref) ist, das höchstwertigste Bit ($D_7$) des anfänglichen digitalen Wertes fixiert wird, bis die A/D-Konversion beendet ist, unabhängig von den Ergebnissen der Bestimmungen durch den Komparator bei den folgenden Vergleichsschritten.

2. Ein A/D-Konverter nach Anspruch 1, bei dem eine Referenzspannung von wenigstens 3/4 eines maximal zulässigen Wertes der analogen Eingangsspannung als die Referenzspannung (Ref) verwendet wird, größer als die Hälfte eines maximal zulässigen Wertes der genannten analogen Eingabe.

3. Ein A/D-Konverter nach Anspruch 1 oder 2, bei dem die sequentielle Vergleichssteuerschaltung (3) ferner eine Vielzahl von Schieberegistern (11a bis 11h) umfaßt, deren Zahl gleich der Zahl der Bits in dem digitalen Wert ist, welche in Reihe verbunden sind und durch Taktimpulse ($\Phi_A$, $\Phi_B$) getrieben werden, und wenn das erste Schieberegister (11a) einen Startimpuls (START) empfängt, die genannten Schieberegister entsprechende Impulse ($\Phi_7$ ... $\Phi_0$) ausgeben, die sequentiell verschoben werden,

jedes der sequentiellen Vergleichsregister (12a bis 12h) durch den Ausgang ($\Phi_7$ ... $\Phi_0$) eines entsprechenden der Schieberegister (11a ... 11h) getrieben wird, und durch den genannten Startimpuls (START); und

eine zweite Inverterschaltung (14), die zwischen dem Eingang des Startimpulses (START) in das genannten Vergleichsregister (12b), welches das nächsthöchstwertigste Bit empfängt, und dem Eingang des Startimpulses in das benachbarte sequentielle Vergleichsregister (12c) verbunden ist.

*Fig. 1*

ANALOG SIGNAL

COMPARATOR 1

SEQUENTIAL COMPARISON CONTROL CIRCUIT ~3

ref

2~ D/A CONVERTER

$D_7$ $D_6$ $D_5$

$D_0$

$D_7$ $D_6$ $D_5$ $D_0$

*Fig. 2A*

BALANCE

AN — $Q_1$  5  7  $Q_3$  $V_{CMP}$

ref — $Q_2$

CPE  A  4  B  C  D  E

*Fig. 2B*

(a) AN

(b) BALANCE H / L

(c) CPE H / L

(d) ref  D/A

(e) $V_{CMP}$  1 or 0

*Fig. 2C*

OUTPUT

b

$C_0$

INPUT

a

# Fig. 3A

# Fig. 3B

EP 0 140 507 B1

Fig. 4

11

# Fig. 5

Fig. 6

EP 0 140 507 B1

*Fig. 7*

*Fig. 8A*

*Fig. 8B*